# EUROPEAN PATENT APPLICATION

(11) **EP 4 672 586 A1**
(43) Date of publication of application: **31.12.2025**
(21) Application number: 24778297.2
(22) Date of filing: 30.03.2024
(51) Int. Cl.: H02M 7/00, H05K 7/20, H05K 7/02

(54) **INVERTER APPARATUS**

(30) Priority: 30.03.2023 CN 202310357655
(71) Applicant: Huawei Digital Power Technologies Co., Ltd., Shenzhen, Guangdong 518043 (CN)
(72) Inventor: CHEN, Dong, Shenzhen, Guangdong 518043 (CN); MA, Zheng, Shenzhen, Guangdong 518043 (CN); WANG, Chen, Shenzhen, Guangdong 518043 (CN); SHI, Lei, Shenzhen, Guangdong 518043 (CN)
(74) Representative: Gill Jennings & Every LLP
(86) International application number: PCT/CN2024/085105
(87) International publication number: WO 2024/199512

(57) **Abstract**

This application provides an inverter device. The inverter device includes an inverter circuit, a housing, a first component, and a second component. The inverter circuit includes a circuit substrate, a switching device, and a through-hole device. Pins of the switching device and pins of the through-hole device are mounted on a same surface of the circuit substrate. The inverter circuit is mounted in a cavity formed by the housing. A surface, facing the circuit substrate, of a bottom plate of the housing includes a supporting component. A body of the switching device is carried on the supporting component. The first component is located between the body of the switching device and the supporting component, and the first component is made of a thermally conductive insulation material. The second component is configured to connect the body of the switching device to the supporting component. The pins of the switching device and the pins of the through-hole device are mounted on the same surface of the circuit substrate, and the first component and the second component are disposed. Therefore, in this application, the inverter device can be manufactured through a convenient manufacturing process, and heat dissipation of the switching device in the inverter device can also be ensured.

## Description

This application claims priority to Chinese Patent Application No. 202310357655.3, filed with the China National Intellectual Property Administration on March 30, 2023 and entitled "INVERTER DEVICE", which is incorporated herein by reference in its entirety.

### TECHNICAL FIELD

This application relates to the field of electrical technologies, and more specifically, to an inverter device.

### BACKGROUND

With booming development of new energy technologies, new energy-related electronic devices such as photovoltaic inverters and motor drives have attracted wide attention from people. These electronic devices usually include an enclosure, electronic components, and a printed circuit board. The electronic components are electrically connected through the printed circuit board. The electronic components and the printed circuit board form a circuit. The enclosure is configured to prevent rain, moisture, dust, and the like from penetrating into the enclosure to damage the circuit.

During operation of the foregoing electronic devices, a loss occurs in the circuit. The loss occurs mainly because the electronic components generate a large amount of heat. A switching device is one of components that generate a large amount of heat. To facilitate heat dissipation, the switching device may be in contact with a bottom plate of a lower housing of the enclosure through a thermal interface material (thermal interface material, TIM). In this case, the switching device needs to first get in contact with the bottom plate of the lower housing of the enclosure, and then the switching device is electrically connected to the printed circuit board through a selective wave soldering manufacturing process or a manual soldering process. However, reliability of manual soldering is poor. In addition, during the selective wave soldering manufacturing process, large space needs to be reserved at a position, on the printed circuit board, that corresponds to the switching device, and the entire lower housing of the enclosure needs to undergo the selective wave soldering manufacturing process on a pipeline. This reduces compactness of the printed circuit board and production efficiency for the electronic device.

Therefore, how to achieve both good heat dissipation performance and a convenient manufacturing process is a problem that urgently needs to be resolved currently.

### SUMMARY

This application provides an inverter and an electronic device, to achieve both good heat dissipation performance and a convenient manufacturing process.

According to a first aspect, an inverter device is provided. The inverter device includes an inverter circuit, a housing, a first component, and a second component. The inverter circuit includes a circuit substrate, a switching device, and a through-hole device. The switching device includes a body and pins. The through-hole device includes a body and pins. The pins of the switching device and the pins of the through-hole device are mounted on a same surface of the circuit substrate. The housing is configured to form a first cavity, and the inverter circuit is accommodated in the first cavity. A surface, facing the circuit substrate, of a bottom plate of the housing includes a supporting component. The body of the switching device is carried on the supporting component. The supporting component is made of a thermally conductive material. The first component is located between the body of the switching device and the supporting component, and the first component is made of a thermally conductive insulation material. The second component is configured to connect the body of the switching device to the supporting component. The inverter circuit is configured to convert a direct current input to the inverter device into an alternating current.

Specifically, the inverter circuit can implement conversion between different levels of voltages by using the switching device. For example, the switching device is configured to convert a direct current into an alternating current, or is configured to convert an alternating current into a direct current, or is configured to convert a low voltage into a high voltage, or is configured to convert a high voltage into a low voltage. The through-hole device in the inverter circuit can be configured to assist in converting a direct current into an alternating current.

In this application, the pins of the switching device and the pins of the through-hole device can be mounted on the same surface of the circuit substrate through a wave soldering manufacturing process. When the inverter circuit is mounted downward into the cavity formed by the housing, no additional mounting operation needs to be performed for the switching device or the through-hole device. Because the switching device does not need to undergo an additional manual soldering process or selective wave soldering manufacturing process, reliability of the switching device can be improved, and compactness of the inverter circuit and production efficiency for the inverter device can also be improved.

With the foregoing structure, in this application, the inverter device can have both a convenient manufacturing process and good heat dissipation performance.

In a possible implementation, the second component includes any one of the following: a batten component, a heat dissipation block component, and a fastener.

With any one of the batten component, the heat dissipation block component, and the fastener, in this application, it can be ensured that a distance between the body of the switching device and the supporting component is shortened as much as possible, so that heat dissipation efficiency for the switching device can be improved.

In a possible implementation, the second component is the batten component, the body of the switching device is located between the batten component and the supporting component, and the batten component is configured to press the body of the switching device toward the supporting component.

With the batten component, in this application, after the inverter circuit is first mounted to the housing, it can still be ensured that a distance between the body of the switching device and the supporting component is shortened as much as possible, so that heat dissipation efficiency for the switching device can be improved.

In a possible implementation, the second component is the heat dissipation block component, the body of the switching device is fastened to the heat dissipation block component, and the heat dissipation block component is connected to the supporting component. The first component is located between the body of the switching device and the heat dissipation block component, or the first component is located between the heat dissipation block component and the supporting component.

Specifically, the body of the switching device may be carried on the supporting component through the heat dissipation block component. The heat dissipation block component is configured to pull the body of the switching device toward the supporting component.

With the heat dissipation block component, in this application, after the inverter circuit is first mounted to the housing, it can still be ensured that a distance between the body of the switching device and the supporting component is shortened as much as possible, so that heat dissipation efficiency for the switching device can be improved.

In a possible implementation, the second component is the fastener, and the body of the switching device, the batten component, or the heat dissipation block component is placed between the fastener and the supporting component.

It can be understood that the fastener can be configured to press the body of the switching device, the batten component, or the heat dissipation block component toward the supporting component.

Specifically, the fastener may be a screw, a nut, or another object.

With the fastener, in this application, after the inverter circuit is first mounted to the housing, it can still be ensured that a distance between the body of the switching device and the supporting component is shortened as much as possible, so that heat dissipation efficiency for the switching device can be improved.

In a possible implementation, the supporting component includes a first surface and a second surface. The first surface is in contact with the surface, facing the circuit substrate, of the bottom plate of the housing. The second surface is used for placing the body of the switching device.

The supporting component is configured to include the first surface and the second surface, the first surface is used to connect to the housing, the second surface is used for placing the body of the switching device, and there is a specific height between the first surface and the second surface. This can implement contact between the body of the switching device and the housing, to transfer heat generated by the switching device to the housing and the ground through the supporting component.

In a possible implementation, the batten component includes a fastening part and a connection part. The fastening part is configured to compress contact between the body of the switching device and the supporting component. The body of the switching device is located between the fastening part and the supporting component. The connection part is connected to the supporting component through the fastener.

Specifically, when the batten component is a regular block structure (refer to FIG. 4), the regular block structure includes a fastening part and a connection part. The fastening part is configured to compress contact between the body of the switching device and the supporting component. The connection part is configured to connect to the supporting component through the fastener or the like. The fastener may be a screw or another object. For the regular block, the fastening part is located at a center of the regular block, and the connection part is located on two sides of the regular block. When the batten component is of another structure (refer to FIG. 5 or FIG. 6), the fastening part and the connection part are different parts.

With the foregoing structure, in this application, the batten component can be connected to the supporting component, and may be further configured to compress contact between the body of the switching device and the supporting component.

In a possible implementation, a form of the thermally conductive insulation material includes any one of the following: a ceramic wafer, a thermally conductive insulation film, a thermally conductive insulation pad, a thermally conductive insulation adhesive, and a thermally conductive insulation tape.

In this way, in this application, the switching device can better dissipate heat to a surrounding environment.

In a possible implementation, the inverter device further includes a magnetic power device. The magnetic power device includes a body and pins. The pins of the magnetic power device are mounted on the same surface.

In the foregoing manner of mounting the magnetic power device, in this application, a connection wire between the magnetic power device and the circuit substrate can be omitted, to reduce material costs and manufacturing costs of the magnetic power device. In addition, a position of an electrical connection between the magnetic power device and the circuit substrate is fixed, without an electrical connection error, so that production efficiency can be improved.

In a possible implementation, the surface includes a first plane and a second plane, and the first plane and the second plane are respectively located on two sides of the supporting component.

The first plane and the second plane are provided. Therefore, in this application, specific empty space may be reserved between the circuit substrate and the bottom plate of the housing. This facilitates heat dissipation for the circuit substrate. In addition, electronic components that generate different amounts of heat may be separately placed in space between the first plane and the circuit substrate and in space between the second plane and the circuit substrate, to facilitate heat dissipation designs for different electronic components and improve reliability of an electronic component with low resistance to temperature.

In a possible implementation, the first plane is flush with the second plane.

This improves flatness of the bottom plate of the housing, to reduce costs of the housing.

In a possible implementation, the supporting component is integrated with the bottom plate of the housing.

This improves convenience of a manufacturing process.

In a possible implementation, the first plane includes a second cavity, and all or a part of the body of the through-hole device is located in the second cavity.

The cavity is provided on the first plane, and a part or all of the through-hole device is located in the cavity. This can reduce electromagnetic interference between the through-hole device and other electronic components, and reduce impact between heat dissipation for the through-hole device and heat dissipation for other heat generating components, to facilitate a heat dissipation design.

In a possible implementation, the second plane includes a third cavity, and all or a part of the body of the magnetic power device is located in the third cavity.

The cavity is provided on the second plane, and a part or all of the magnetic power device is located in the cavity. This can reduce electromagnetic interference between the magnetic power device and other electronic components, and reduce impact between heat dissipation for the through-hole device and heat dissipation for other heat generating components, to facilitate a heat dissipation design.

In a possible implementation, a material of the heat dissipation block is a metal material.

This helps improve efficiency of transferring heat generated by the switching device to the supporting component.

In a possible implementation, a surface, backing the circuit substrate, of the bottom plate includes a heat dissipation component.

This helps improve efficiency of dissipating heat by the inverter device to a surrounding environment.

According to a second aspect, an electronic device is provided, including the inverter device according to any one of the first aspect or the implementations of the first aspect, a communication unit, and a control unit. The communication unit is configured to input an instruction, and send the instruction to the control unit. The control unit is configured to control the inverter device according to the instruction.

In a possible implementation, the electronic device further includes a transformer unit, configured to convert an input voltage of the electronic device into a direct current voltage, and provide the direct current voltage for the inverter device according to any one of the first aspect or the implementations of the first aspect. Alternatively, the transformer device is configured to convert a voltage provided by the inverter device according to any one of the first aspect or the implementations of the first aspect into a direct current voltage, and provide the direct current voltage for another device, for example, an energy storage system or a battery pack.

### BRIEF DESCRIPTION OF DRAWINGS

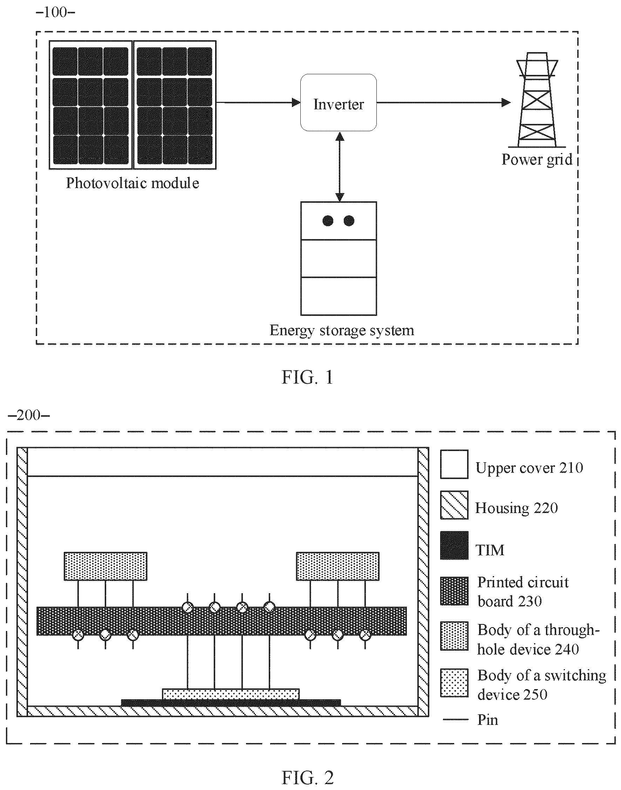

FIG. 1 is a diagram of an application scenario 100 according to an embodiment of this application;
FIG. 2 is a diagram of a structure of an inverter device 200;

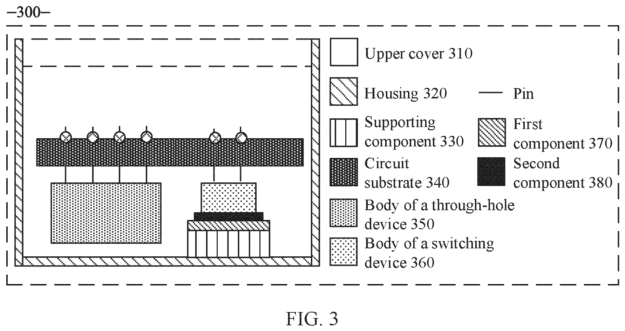

FIG. 3 is a diagram of a structure of an inverter device 300 according to an embodiment of this application;

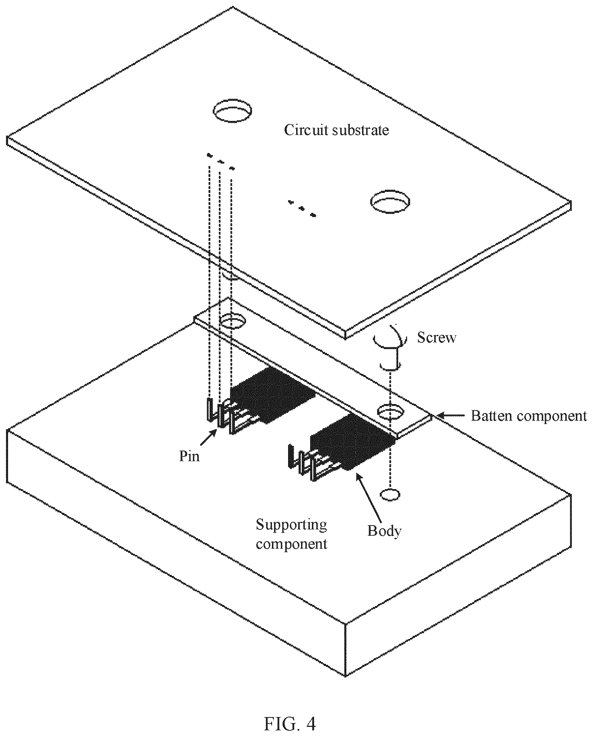

FIG. 4 is a diagram of a structure of a batten component 400 according to an embodiment of this application;

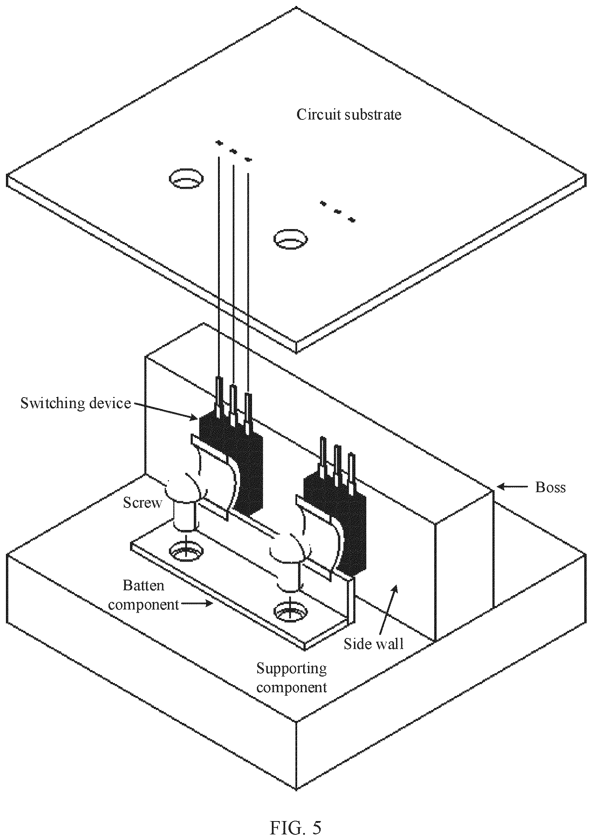

FIG. 5 is a diagram of a structure of a batten component 500 according to an embodiment of this application;

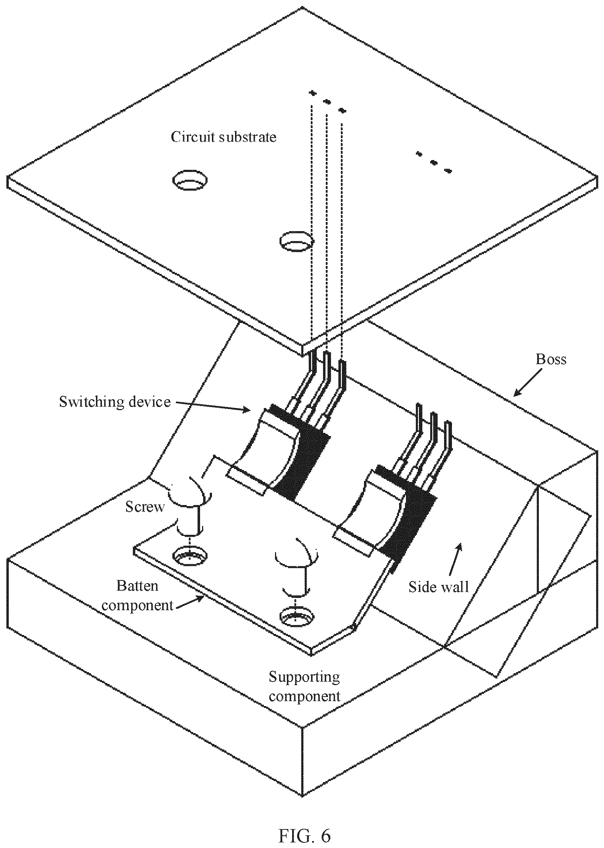

FIG. 6 is a diagram of a structure of a batten component 600 according to an embodiment of this application;

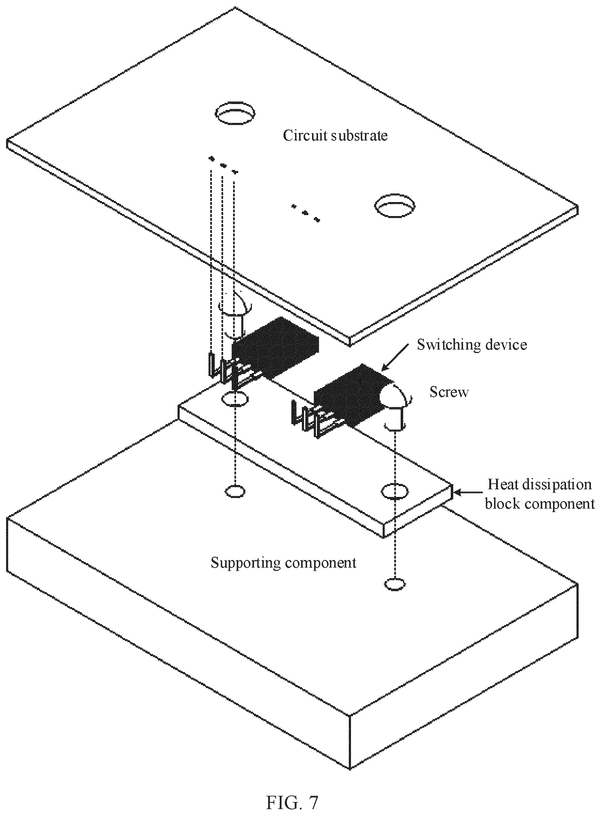

FIG. 7 is a diagram of a structure of a heat dissipation block component 700 according to an embodiment of this application;

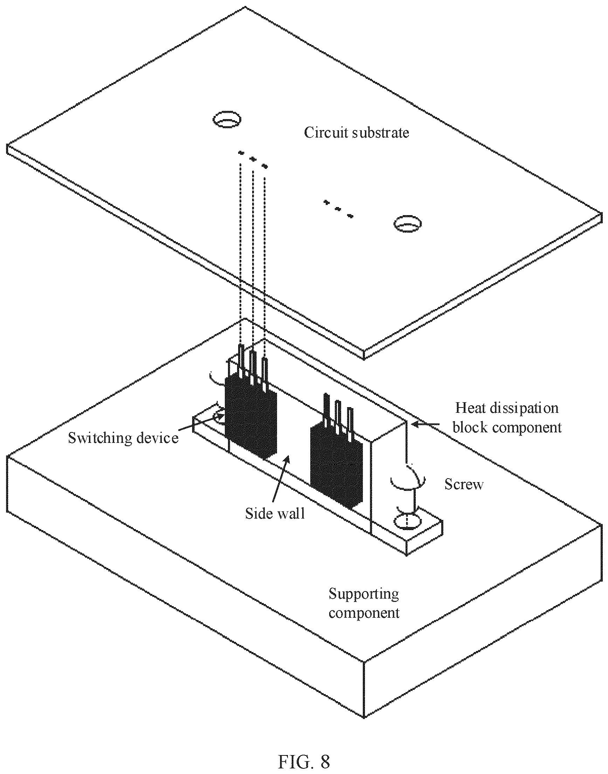

FIG. 8 is a diagram of a structure of a heat dissipation block component 800 according to an embodiment of this application;

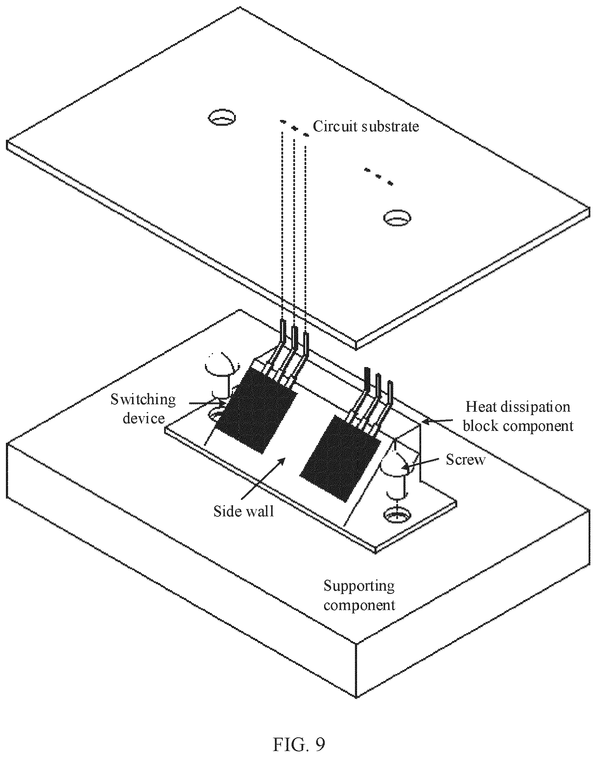

FIG. 9 is a diagram of a structure of a heat dissipation block component 900 according to an embodiment of this application;

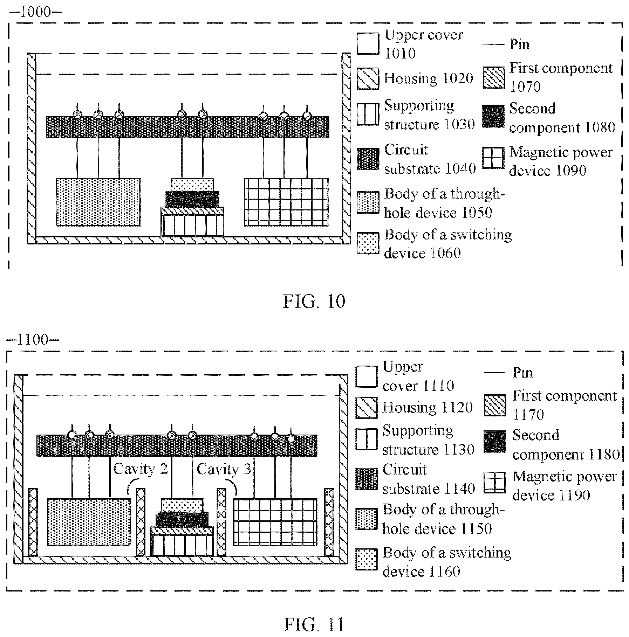

FIG. 10 is a diagram of a structure of an inverter device 1000 according to an embodiment of this application;
FIG. 11 is a diagram of a structure of an inverter device 1100 according to an embodiment of this application;

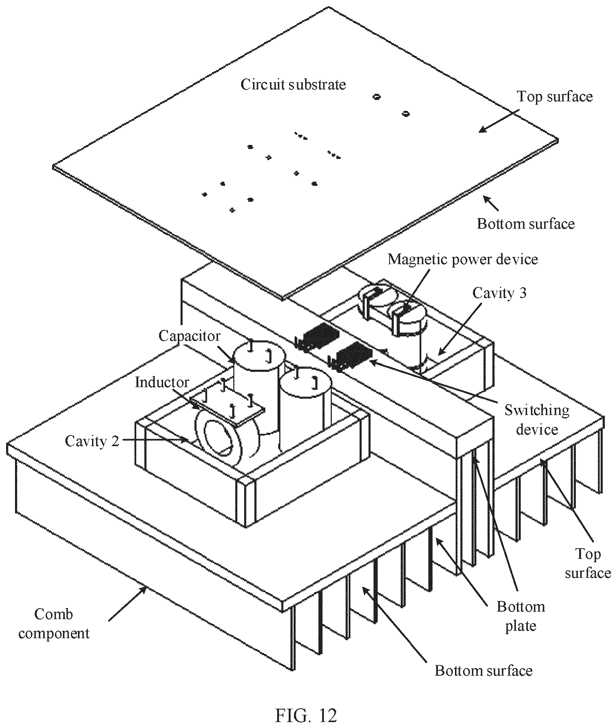

FIG. 12 is a diagram of a structure of an inverter device 1200 according to an embodiment of this application; and

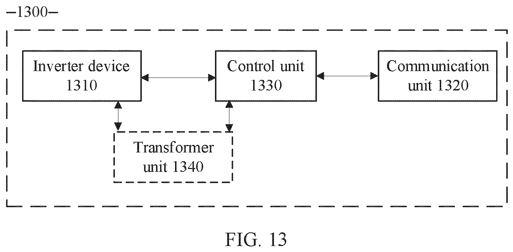

FIG. 13 is a diagram of a structure of an electronic device 1300 according to an embodiment of this application.

### DESCRIPTION OF EMBODIMENTS

The following describes technical solutions of this application with reference to accompanying drawings.

An inverter is an apparatus capable of converting a direct current into an alternating current, and usually includes an inverter bridge, a controller, and a filter circuit. The inverter may be widely used in many fields. For details, refer to FIG. 1.

FIG. 1 is a diagram of an application scenario 100 according to an embodiment of this application. As shown in FIG. 1, an inverter device may be used in an energy storage system, a photovoltaic power generation system, a power grid, and other scenarios. When the inverter device is used in a scenario with a photovoltaic power generation system, the inverter device converts a direct current output by the photovoltaic power generation system into an alternating current, and transmits the alternating current to a power grid or a load. When the inverter device is used in an energy storage system, the inverter device converts electric energy stored in the energy storage system from a direct current into an alternating current, and transmits the alternating current to a power grid or a load. For an internal structure of the inverter device, refer to FIG. 2.

FIG. 2 is a diagram of a structure of an inverter device 200. As shown in FIG. 2, the inverter device 200 includes an upper cover 210, a housing 220, a printed circuit board 230, a through-hole device 240 (for example, a filter capacitor and a filter inductor), and a switching device 250.

During operation of the inverter device 200, the printed circuit board 230, the through-hole device 240, and the switching device 250 generate a large amount of heat. The switching device 250 is one of main devices that generate a large amount of heat. To better diffuse heat generated by the switching device 250 to a surrounding environment through the housing 220, the switching device 250 needs to get in contact with the housing 220 through a TIM. To be specific, the switching device 250 is disposed between the printed circuit board 230 and the housing 220. The through-hole device 240 generates a small amount of heat and therefore is mounted on a top surface of the printed circuit board 230. To be specific, the through-hole device 240 is disposed between the upper cover 210 and the printed circuit board 230.

Specifically, a body of the through-hole device 240 is placed on the top surface of the printed circuit board 230, and pins of the through-hole device 240 are soldered to a bottom surface of the printed circuit board 230 through a wave soldering manufacturing process. When the printed circuit board 230 is mounted in the housing 220, no additional mounting operation needs to be performed for the through-hole device 240. After a body of the switching device 250 gets in contact with the housing 220 through the TIM, pins of the switching device 250 further need to be electrically connected to the printed circuit board 230 through a manual soldering process or a selective wave soldering manufacturing process. However, reliability of the manual soldering process is poor. In addition, during the selective wave soldering manufacturing process, large space needs to be reserved at a position, on the printed circuit board 230, that corresponds to the switching device 250, and the entire housing 220 needs to undergo the selective wave soldering manufacturing process on a pipeline. This reduces compactness of the printed circuit board 230 and production efficiency for the inverter device 200.

For the inverter device 200, the foregoing structure can ensure specific heat dissipation performance, but a manufacturing process is not sufficiently convenient, leading to low production efficiency, high overall costs, and other problems.

In view of this, this application provides an inverter device, to achieve both good heat dissipation performance and a convenient manufacturing process.

The following describes the inverter device in embodiments of this application with reference to accompanying drawings.

FIG. 3 is a diagram of a structure of an inverter device 300 according to an embodiment of this application. As shown in FIG. 3, the inverter device 300 includes an upper cover 310 (this is an optional structure), a housing 320, an inverter circuit, a first component 370, and a second component 380. The inverter circuit includes a circuit substrate 340, a through-hole device 350, and a switching device 360. A plane, facing the circuit substrate 340, of a bottom plate of the housing 320 includes a supporting component 330. The inverter circuit may be configured to convert a direct current input to the inverter device 300 into an alternating current.

Specifically, the through-hole device 350 is a device with pins, for example, a filter capacitor, a filter inductor, a common-mode inductor, a bus capacitor, a resistor, an overcurrent or short-circuit protection device, an overtemperature protection device, or a lightning arrester. The switching device 360 includes but is not limited to an insulated gate bipolar transistor (insulated gate bipolar transistor, IGBT), a high-power transistor, a bidirectional transistor, a thyristor, a gate turn-off thyristor (gate turn-off thyristor, GTO) device, and a metal-oxide-semiconductor field-effect transistor (metal-oxide-semiconductor field-effect transistor, MOSFET).

The inverter circuit may be configured to implement conversion between different levels of voltages by using the switching device 360. For example, the switching device 360 can be configured to convert a direct current into an alternating current, or can be configured to convert an alternating current into a direct current, or can be configured to convert a low voltage into a high voltage, or can be configured to convert a high voltage into a low voltage. The through-hole device 350 can be configured to assist in converting a direct current into an alternating current.

As shown in FIG. 3, the housing 320 is configured to form a cavity 1, and the cavity 1 is configured to accommodate the inverter circuit.

As shown in FIG. 3, the first component 370 is made of a thermally conductive insulation material. The first component 370 is disposed between a body of the switching device 360 and the supporting component 330. In this way, the first component 370 can be configured to not only implement an insulation connection between the body of the switching device 360 and the supporting component 330, but also transfer heat generated by the switching device 360 to the supporting component 330.

In a possible implementation, a form of the thermally conductive insulation material used to form the first component 370 includes but is not limited to a ceramic wafer, a thermally conductive insulation film, a thermally conductive insulation pad, a thermally conductive insulation adhesive, and a thermally conductive insulation tape. It can be understood that another possible material of the first component 370 is not limited in this application.

As shown in FIG. 3, the second component 380 is disposed between the body of the switching device 360 and the supporting component 330, and the second component 380 can be configured to connect the body of the switching device 360 to the supporting component 330, and can perform a function of fastening the connection between the body of the switching device 360 and the supporting component 330.

It can be understood that a relative relationship between the first component and the second component may include: The first component is located between the second component and the supporting component; or the first component is located between the body of the switching device and the second component. This is not limited herein.

In a possible implementation, the second component 380 includes at least one of the following: a batten component, a heat dissipation block component, a fastener, and the like. Details are described below.

As shown in FIG. 3, pins of the switching device 360 and pins of the through-hole device 350 are mounted on a same surface of the circuit substrate 340 (for example, a surface, facing the upper cover 310, of the circuit substrate 340, or a top surface of the circuit substrate 340), and the body of the switching device 360 and a body of the through-hole device 350 face another surface of the circuit substrate 340 (for example, a surface, facing the bottom plate of the housing 320, of the circuit substrate 340, or a bottom surface of the circuit substrate 340).

As shown in FIG. 3, both the pins of the through-hole device 350 and the pins of the switching device 360 are mounted on a same surface of the circuit substrate 340. To be specific, both the pins of the through-hole device 350 and the pins of the switching device 360 are soldered on the top surface of the circuit substrate 340. Cross-texture circles shown in FIG. 3 may represent solder joints between the pins of the switching device 360 or the through-hole device 350 and the top surface of the circuit substrate 340.

It can be understood that the supporting component 330 is made of a thermally conductive material. Optionally, the supporting component 330 may be integrated with the bottom plate of the housing 320, or may be an independent component.

In a possible implementation, the supporting component 330 includes a first surface and a second surface. The first surface is connected to a surface, facing the circuit substrate 340, of the bottom plate of the housing 320. The second surface is used for placing the body of the switching device 360. There is a specific angle (which may be 0°, 90°, or another angle) between the first surface and the second surface. For descriptions of the first surface and the second surface, refer to the following descriptions. The supporting component 330 is configured to include the first surface and the second surface, the first surface is used to connect to the housing 320, the second surface is used for placing the body of the switching device 360, and there is a specific height between the first surface and the second surface. This can implement contact between the body of the switching device 360 and the housing 320, to transfer heat generated by the switching device 360 to the housing 320 and the ground through the supporting component 330.

In a possible implementation, the batten component includes a fastening part and a connection part. The fastening part is configured to compress contact between the body of the switching device 360 and the supporting component 330. The body of the switching device 360 is located between the fastening part and the supporting component 330. The connection part is connected to the supporting component 330 through the fastener.

When the batten component is a regular block structure (refer to FIG. 4), the regular block structure includes a fastening part and a connection part. The fastening part is configured to compress contact between the body of the switching device 360 and the supporting component 330. The connection part is configured to connect to the supporting component 360 through the fastener or the like. The fastener may be a screw or another object. For the regular block, the fastening part is located at a center of the regular block, and the connection part is located on two sides of the regular block. When the batten component is of another structure (refer to FIG. 5 or FIG. 6), the fastening part and the connection part are different parts. The fastener may alternatively be a component of the batten component. This is not limited herein.

With the foregoing batten structure, in this application, the batten component can be connected to the supporting component, and may be further configured to compress contact between the body of the switching device and the supporting component.

It can be understood that the through-hole device 350 is usually light in mass and may be suspended between the circuit substrate 340 and the bottom plate of the housing 320, and no structure similar to the supporting component 330 needs to be added.

Optionally, a TIM material such as a thermally conductive insulation adhesive or a thermally conductive insulation pad may be added between the through-hole device 350 and the bottom plate of the housing 320. This can improve efficiency of dissipating heat by the through-hole device 350 to a surrounding environment.

It can be understood that the circuit substrate 340 may be a printed circuit board (printed circuit board, PCB). When the circuit substrate 340 is a PCB, the circuit substrate 340 may be a multilayer circuit board or a single-sided circuit board. This is not limited herein.

Before the inverter circuit (or the circuit substrate 340) is mounted to the housing 320, this application supports pre-mounting of the first component 370 and the second component 380. After the inverter circuit (or the circuit substrate 340) is mounted, a tool such as a screwdriver is used to pass through a through-hole on the circuit substrate 340 to tighten a fastening screw of the second component 380, so that the second component 380 is securely connected to the supporting component 330. This ensures that a distance between the body of the switching device 360 and the supporting component 330 is shortened as much as possible, and improves heat dissipation efficiency for the switching device 360.

In this application, the pins of the switching device 360 and the pins of the through-hole device 350 can be mounted on the same surface of the circuit substrate 340 through a wave soldering manufacturing process. When the inverter circuit is mounted downward into the cavity formed by the housing 320, no additional mounting operation needs to be performed for the switching device 360 or the through-hole device 350. Because the switching device 360 does not need to undergo an additional manual soldering process or selective wave soldering manufacturing process, reliability of the switching device 360 can be improved, and compactness of the inverter circuit and production efficiency for the inverter device can also be improved.

With the foregoing structure, in this application, the inverter device can have both a convenient manufacturing process and good heat dissipation performance.

The following further describes the inverter 300 shown in FIG. 3 with reference to other accompanying drawings.

FIG. 4 is a diagram of a structure of a batten component 400 according to an embodiment of this application. The batten component 400 is an example of the second component 380. As shown in FIG. 4, the body of the switching device 360 is disposed on the supporting component 330. The pins of the switching device 360 pass through through-holes on the circuit substrate 340 and reach the top surface of the circuit substrate 340 (for pass-through paths, refer to white dashed lines shown in FIG. 4), and are soldered. Before the circuit substrate 340 is mounted, the batten component 400 is pre-mounted between the switching device 360 and the circuit substrate 340. After the circuit substrate 340 is mounted, a tool such as a screwdriver is used to pass through through-holes on the circuit substrate 340 to tighten fastening screws of the batten component 400, so that the batten component 400 is securely connected to the supporting component 330, and the body of the switching device 360 is pressed toward a top surface of the supporting component 330. The body of the switching device 360 is located between the batten 400 and the top surface of the supporting component 330, and the switching device 360 may be further in contact with the top surface of the supporting component 330 through the first component 370 (for example, a TIM such as a ceramic wafer or a thermally conductive insulation film).

With the batten component, in this application, after the circuit substrate is first mounted to the housing, it can still be ensured that a distance between the body of the switching device 360 and the supporting component 330 is shortened as much as possible, so that heat dissipation efficiency for the switching device 360 can be improved.

In the structure shown in FIG. 4, the first surface and the second surface of the supporting component are two surfaces that are parallel to each other. In other words, the supporting component is a cube, and an upper surface and a lower surface of the cube are the second surface and the first surface respectively.

It can be learned from FIG. 4 that the fastening part and the connection part of the batten component are located on a same plane, the connection part includes through-holes, and the batten component is connected to the supporting component through the through-holes on the connection part, the fastener, and the like. The batten component compresses contact between the body of the switching device and the supporting component through the fastening part. In FIG. 4, the fastening part is a part of the batten structure other than the through-holes, and the connection part is a part, including the through-holes, of the batten component.

FIG. 5 is a diagram of a structure of a batten component 500 according to an embodiment of this application. The batten component 500 is another example of the second component 380. The batten component 500 is different from the batten component 400. As shown in FIG. 5, a top surface of the supporting component 330 includes a boss, and the boss includes a side wall perpendicular to the top surface of the supporting component 330. The batten component 500 includes a press-fitting surface parallel to the side wall and a mounting surface parallel to the top surface of the supporting component 330.

After the mounting surface of the batten component 500 is fastened to the top surface of the supporting component 330, the press-fitting surface of the batten component 500 presses the body of the switching device 360 toward the side wall of the boss. The press-fitting surface of the batten component 500 is provided at a position corresponding to the body of the switching device 360, and the batten component 500 may be an elastic spring plate or the like. This helps simplify mounting, and can ensure that a distance between the body of the switching device 360 and the supporting component 330 and a distance between the body of the switching device 360 and the boss are shortened as much as possible.

Optionally, the boss may be integrated with the supporting component 330; or may be a separate mechanical part, and is pre-mounted on the supporting component 330 and is in contact with the supporting component 330 through a TIM.

Specifically, because the body of the switching device 360 is kept in a perpendicular arrangement relationship with the top surface of the supporting component 330, the switching device 360 is also kept in a perpendicular arrangement relationship with the circuit substrate 340. This can reduce a board area occupied by the switching device 360 on the circuit substrate 340, and improve compactness of the circuit substrate 340. In addition, the pins of the switching device 360 are also kept in a perpendicular arrangement relationship with the circuit substrate 340. Therefore, a manufacturing process in which the switching device 360 is soldered on the circuit substrate 340 can be completed without bending the pins of the switching device 360, so that production efficiency can be improved.

In the structure shown in FIG. 5, the first surface and the second surface of the supporting component are two surfaces that are perpendicular to each other. In other words, the supporting component is a cube including a boss, and a side surface of the boss is the second surface.

It can be learned from FIG. 5 that the fastening part and the connection part of the batten component are located on different planes, the connection part includes through-holes, and the batten component is connected to the supporting component through the through-holes on the connection part, the fastener, and the like. The batten component compresses contact between the body of the switching device and the supporting component through the fastening part. In FIG. 5, the fastening part is a part of the batten structure other than the through-holes, and the connection part is a part, including the through-holes, of the batten component.

FIG. 6 is a diagram of a structure of a batten component 600 according to an embodiment of this application. The batten component 600 is still another example of the second component 380. The batten component 600 is different from the batten component 400 and the batten component 500. As shown in FIG. 6, a top surface of the supporting component 330 includes a boss, and the boss includes a side wall that is kept at a preset angle (which may be, for example, any angle value ranging from 90° to 180°) with the top surface of the supporting component 330. The batten component 600 includes a press-fitting surface parallel to the side wall and a mounting surface parallel to the top surface of the supporting component 330.

After the mounting surface of the batten component 600 is fastened to the top surface of the supporting component 330, the press-fitting surface of the batten component 600 presses the body of the switching device 360 toward the side wall of the boss. The press-fitting surface of the batten component 600 is provided at a position corresponding to the body of the switching device 360, and the batten component 600 may be an elastic spring plate or the like. This helps simplify mounting, and can ensure that a distance between the body of the switching device 360 and the supporting component 330 and a distance between the body of the switching device 360 and the boss are shortened as much as possible.

Optionally, the boss may be integrated with the supporting component 330; or may be a separate mechanical part, and is pre-mounted on the supporting component 330 and is in contact with the supporting component 330 through a TIM.

With the supporting component 330 and the batten component 600, in this application, a board area occupied by the switching device 360 on the circuit substrate 340 can be reduced. This helps improve compactness of the circuit substrate 340.

In the structure shown in FIG. 6, the first surface and the second surface of the supporting component are two surfaces that meet a specific included angle. In other words, the supporting component is a cube including a boss, and a side surface of the boss is the second surface.

It can be learned from FIG. 6 that the fastening part and the connection part of the batten component are located on different planes, the connection part includes through-holes, and the batten component is connected to the supporting component through the through-holes on the connection part, the fastener, and the like. The batten component compresses contact between the body of the switching device and the supporting component through the fastening part. In FIG. 6, the fastening part is a part of the batten structure other than the through-holes, and the connection part is a part, including the through-holes, of the batten component. It should be noted that the batten components shown in FIG. 4 to FIG. 6 are merely examples for understanding, and possible structural forms other than the batten components shown in FIG. 4 to FIG. 6 are not limited in this application.

It can be understood that, in the batten components shown in FIG. 4 to FIG. 6, the first component 370 may be located between the batten component and the supporting component.

FIG. 7 is a diagram of a structure of a heat dissipation block component 700 according to an embodiment of this application. The heat dissipation block component 700 is an example of the second component 380. As shown in FIG. 7, the body of the switching device 360 is pre-mounted with the heat dissipation block component 700 through bonding. The pins of the switching device 360 pass through through-holes on the circuit substrate 340 and reach the top surface of the circuit substrate 340 (for pass-through paths, refer to black dashed lines shown in FIG. 7), and are soldered. Before the circuit substrate 340 is mounted, the heat dissipation block component 700 is pre-mounted between the switching device 360 and the circuit substrate 340. After the circuit substrate 340 is mounted, the heat dissipation block component 700 is also disposed between the switching device 360 and a top surface of the supporting component 330, and a tool such as a screwdriver is used to pass through through-holes on the circuit substrate 340 to tighten fastening screws of the heat dissipation block component 700, so that the heat dissipation block component 700 is securely connected to the supporting component 330, and the body of the switching device 360 is pulled toward the top surface of the supporting component 330. The heat dissipation block component 700 is located between the body of the switching device 360 and the top surface of the supporting component 330, and the switching device 360 may be further in contact with the heat dissipation block component 700 through the first component 370 (for example, a TIM such as a ceramic wafer or a thermally conductive insulation film). The heat dissipation block component 700 may be in contact with the top surface of the supporting component 330 through a TIM.

With the heat dissipation block component, in this application, after the circuit substrate is first mounted to the housing, it can still be ensured that a distance between the body of the switching device and the supporting component is shortened as much as possible, so that heat dissipation efficiency for the switching device can be improved.

FIG. 8 is a diagram of a structure of a heat dissipation block component 800 according to an embodiment of this application. The heat dissipation block component 800 is another example of the second component 380. As shown in FIG. 8, the heat dissipation block component 800 includes a mounting surface parallel to a top surface of the supporting component 330 and a bonding surface parallel to the body of the switching device 360. The bonding surface and the mounting surface of the heat dissipation block component 800 are kept in a perpendicular arrangement relationship. The switching device 360 is pre-mounted on the bonding surface of the heat dissipation block component 800 through bonding. After the circuit substrate 340 is mounted, the heat dissipation block component 800 is also disposed between the switching device 360 and a top surface of the supporting component 330. In this case, a tool such as a screwdriver is used to pass through through-holes on the circuit substrate 340 to tighten fastening screws of the heat dissipation block component 800, so that the heat dissipation block component 800 is securely connected to the top surface of the supporting component 330, and the body of the switching device 360 is pulled toward the top surface of the supporting component 330.

Specifically, because the body of the switching device 360 is kept in a perpendicular arrangement relationship with the top surface of the supporting component 330, the switching device 360 is also kept in a perpendicular arrangement relationship with the circuit substrate 340. This can reduce a board area occupied by the switching device 360 on the circuit substrate 340, and improve compactness of the circuit substrate 340. In addition, the pins of the switching device 360 are also kept in a perpendicular arrangement relationship with the circuit substrate 340. Therefore, a manufacturing process in which the switching device 360 is soldered on the circuit substrate 340 can be completed without bending the pins of the switching device 360, so that production efficiency can be improved.

FIG. 9 is a diagram of a structure of a heat dissipation block component 900 according to an embodiment of this application. The heat dissipation block component 900 is still another example of the second component 380. The heat dissipation block component 900 is different from the heat dissipation block component 700 and the heat dissipation block component 800. As shown in FIG. 9, the heat dissipation block component 900 includes a mounting surface parallel to a top surface of the supporting component 330 and a bonding surface parallel to the body of the switching device 360. There is a preset angle between the bonding surface and the mounting surface of the heat dissipation block component 900, and the preset angle is any angle value ranging from 90° to 180°. The switching device 360 is pre-mounted on the bonding surface of the heat dissipation block component 900 through bonding. After the circuit substrate 340 is mounted, the heat dissipation block component 900 is also disposed between the switching device 360 and a top surface of the supporting component 330. In this case, a tool such as a screwdriver is used to pass through through-holes on the circuit substrate 340 to tighten fastening screws of the heat dissipation block component 900, so that the heat dissipation block component 900 is securely connected to the top surface of the supporting component 330, and the body of the switching device 360 is pulled toward the top surface of the supporting component 330.

With the heat dissipation block component 900, in this application, a board area occupied by the switching device 360 on the circuit substrate 340 can be reduced. This helps improve compactness of the circuit substrate 340.

It should be noted that the heat dissipation block components shown in FIG. 7 to FIG. 9 are merely examples for understanding, and possible structural forms other than the heat dissipation block components shown in FIG. 7 to FIG. 9 are not limited in this application.

In a possible implementation, the heat dissipation block components shown in FIG. 7 to FIG. 9 are made of a metal material. This helps improve efficiency of transferring heat generated by the switching device to the supporting component.

It can be understood that, in the heat dissipation block components shown in FIG. 7 to FIG. 7, the first component 370 may be located between the heat dissipation block component and the supporting component, or the first component 370 is located between the body of the switching device and the heat dissipation block component.

FIG. 10 is a diagram of a structure of an inverter device 1000 according to an embodiment of this application. As shown in FIG. 10, the inverter device 1000 includes an upper cover 1010 (this is an optional structure), a housing 1020, a supporting component 1030, a circuit substrate 1040, a through-hole device 1050, a switching device 1060, a first component 1070, a second component 1080, and a magnetic power device 1090. For descriptions of components of the inverter component 1000 other than the magnetic power device 1090, refer to the foregoing descriptions. Details are not described herein again.

As shown in FIG. 10, the magnetic power device 1090 is soldered to a bottom surface of the circuit substrate 1040 through a wave soldering manufacturing process, or is pre-mounted on a bottom surface of the circuit substrate 1040 by using a screw or a nut. For the latter, a through-hole needs to be provided at a position, on the circuit substrate 1040, that corresponds to a fastening screw of the magnetic power device 1090. After the circuit substrate 1040 is mounted, the magnetic power device 1090 is securely connected to a bottom plate of the housing 1020 through the fastening screw, and is in contact with a top surface of the bottom plate of the housing 1020 through a TIM. The fastening screw of the magnetic power device 1090 may be tightened to shorten a distance between the magnetic power device 1090 and the top surface of the bottom plate of the housing 1020, so that heat dissipation efficiency for the magnetic power device 1090 can be improved.

Optionally, before the circuit substrate 1040 is mounted, in this application, the magnetic power device 1090 can be securely pre-connected to a bottom plate of the housing 1020 through the fastening screw, and is in contact with a top surface of the bottom plate of the housing 1020 through a TIM. After the circuit substrate 1040 is mounted, the magnetic power device 1090 retains an electrical connection to the circuit substrate 1040 by using a screw or a nut.

It should be noted that the magnetic power device 1090 may be suspended between the circuit substrate 1040 and the bottom plate of the housing 1020, or may be connected to the bottom plate of the housing 1020. This is not limited herein.

In the foregoing manner of mounting the magnetic power device, in this application, a connection wire between the magnetic power device and the circuit substrate 1040 can be omitted, to reduce material costs and manufacturing costs of the magnetic power device. In addition, a position of the electrical connection between the magnetic power device and the circuit substrate 1040 is fixed, without an electrical connection error, so that production efficiency can be improved. In addition, contact is performed through a TIM such as a thermally conductive insulation adhesive or a thermally conductive insulation pad. This helps the magnetic power device dissipate heat to a surrounding environment through the bottom plate of the housing 1020.

FIG. 11 is a diagram of a structure of an inverter device 1100 according to an embodiment of this application. As shown in FIG. 11, the inverter device 1100 includes an upper cover 1110 (this is an optional structure), a housing 1120, a supporting component 1130, a circuit substrate 1140, a through-hole device 1150, a switching device 1160, a first component 1170, a second component 1180, a magnetic power device 1190, a cavity 2, and a cavity 3. For descriptions of components of the inverter 1100 other than the cavity 2 and the cavity 3, refer to the foregoing descriptions. Details are not described herein again.

As shown in FIG. 11, the cavity 2 and the cavity 3 are respectively located on two sides of the supporting component 1130. Specifically, the cavity 2 is located on a first plane, and the cavity 3 is located on a second plane. The first plane and the second plane are respectively located on two sides of the supporting component 1130.

The first plane and the second plane are provided. Therefore, in this application, specific empty space may be reserved between the circuit substrate 1140 and a bottom plate of the housing 1120. This facilitates heat dissipation for the circuit substrate 1140. In addition, electronic components that generate different amounts of heat may be separately placed in space between the first plane and the circuit substrate and in space between the second plane and the circuit substrate, to facilitate heat dissipation designs for different electronic components and improve reliability of an electronic component with low resistance to temperature.

Optionally, the first plane is flush with the second plane. This improves flatness of the bottom plate of the housing 1120, to reduce costs of the housing.

Optionally, the cavity 2 and the cavity 3 are provided on the first plane and the second plane respectively, and a part or all of the through-hole device 1150 and a part or all of the magnetic power device 1190 are located in the cavity 2 and the cavity 3 respectively. This can avoid electromagnetic interference between the magnetic power device 1190 and the through-hole device 1150.

After the circuit substrate 1140 is mounted, a part or all of a body of the through-hole device 1150 is disposed in the cavity 2, and a part or all of a body of the magnetic power device 1190 is disposed in the cavity 3. The cavity 2 and the cavity 3 are provided. Therefore, in this application, mutual impact between heat dissipation for the magnetic power device 1190 disposed in the cavity 2, heat dissipation for the through-hole device 1150 disposed in the cavity 3, and heat dissipation for the switching device 1160 not disposed in an accommodation cavity can be reduced as much as possible, to facilitate a heat dissipation design.

It can be understood that, in FIG. 11, an example in which the inverter 1100 includes the cavity 2 and the cavity 3 is used for description, but a quantity of accommodation cavities included in the inverter 1100 is not limited. For example, the inverter 1100 includes only either of the cavity 2 and the cavity 3, or may further include a cavity 4 or the like. This is not limited herein.

It can be understood that, when the cavity 2 is provided on the first plane, a part or all of the through-hole device 1150 is located in the cavity 2. This can reduce electromagnetic interference between the through-hole device 1150 and other electronic components, and reduce impact between heat dissipation for the through-hole device 1150 and heat dissipation for other heat generating components, to facilitate a heat dissipation design.

It can be understood that, when the cavity 3 is provided on the second plane, a part or all of the magnetic power device 1190 is located in the cavity 3. This can reduce electromagnetic interference between the magnetic power device 1190 and other electronic components, and reduce impact between heat dissipation for the magnetic power device 1190 and heat dissipation for other heat generating components, to facilitate a heat dissipation design.

It should be noted that the magnetic power device 1190 may be suspended between the circuit substrate 1140 and the bottom plate of the housing 1120, or may be connected to the bottom plate of the housing 1120. This is not limited herein.

FIG. 12 is a diagram of a structure of an inverter device 1200 according to an embodiment of this application. As shown in FIG. 12, the inverter device 1200 includes a circuit substrate (including a top surface and a bottom surface), a capacitor, an inductor, a cavity 2, a cavity 3, a magnetic power device, a switching device, a bottom plate (including a top surface and a bottom surface), and a comb component. The capacitor and the inductor are examples of the foregoing through-hole device, and the comb component is an example of a heat dissipation component included on a bottom surface of a bottom plate of a housing. The heat dissipation component is disposed on the bottom surface of the bottom plate of the housing, so that heat dissipation efficiency for the inverter device can be further improved in this application. The comb component shown in FIG. 12 is an example of the heat dissipation component, and other possible structures are not limited in this application.

It should be noted that the inverter device 300 to the inverter device 1200 may further include a fastener, and the fastener is configured to fasten a connection between at least one of the switching device, the batten component, or the heat dissipation block component and the supporting component (or the body of the switching device, the batten component, or the heat dissipation block component is disposed between a part or all of the fastener and the supporting component). In other words, the fastener can be configured to press the body of the switching device, the batten component, or the heat dissipation block component toward the supporting component. The fastener may be an object with a fastening function, for example, a screw or a nut.

FIG. 13 is a diagram of a structure of an electronic device 1300 according to an embodiment of this application. As shown in FIG. 13, the electronic device 1300 includes an inverter device 1310, a communication unit 1320, and a control unit 1330. The inverter device 1310 is any one of the foregoing inverter 300 to inverter 1200, and is configured to implement a function of the inverter device. The communication unit 1320 is configured to input an instruction, and send the instruction to the control unit 1330. The control unit 1330 is configured to control the inverter device 1310 according to the instruction.

In a possible implementation, the electronic device 1300 further includes a transformer unit 1340, configured to convert an input voltage of the electronic device 1300 into a direct current voltage, and provide the direct current voltage for the inverter device 1310.

Optionally, the transformer unit 1340 may be further configured to convert a voltage of the inverter device 1310 into a direct current voltage, and provide the direct current voltage for another device, for example, an energy storage system or a battery pack.

It can be understood that the disclosed apparatuses or components in the several embodiments provided in this application may be implemented in other manners. For example, the described apparatus or component embodiments are merely examples. For example, division into the units is merely logical function division and may be other division during actual implementation. For example, a plurality of units or components may be combined or integrated into another system, or some features may be ignored or not performed. In addition, the shown or discussed mutual couplings or direct couplings or communication connections may be implemented through some interfaces. The indirect couplings or communication connections between the apparatuses or units may be implemented in electrical, mechanical, or other forms.

The units described as separate components may or may not be physically separate, and components shown as units may or may not be physical units, to be specific, may be located in one place, or may be distributed on a plurality of network units. Some or all of the units may be selected according to actual requirements to achieve objectives of solutions of embodiments.

In addition, functional units in embodiments of this application may be integrated into one processing unit, or each unit may exist alone physically, or two or more units may be integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An inverter device, comprising:
an inverter circuit, wherein the inverter circuit comprises a circuit substrate, a switching device, and a through-hole device, the switching device comprises pins and a body, the through-hole device comprises pins and a body, and the pins of the switching device and the pins of the through-hole device are mounted on a same surface of the circuit substrate;
a housing, configured to form a first cavity, wherein the inverter circuit is accommodated in the first cavity, a surface, facing the circuit substrate, of a bottom plate of the housing comprises a supporting component, the body of the switching device is carried on the supporting component, and the supporting component is made of a thermally conductive material; and
a first component, located between the body of the switching device and the supporting component, wherein the first component is made of a thermally conductive insulation material; and a second component, configured to connect the body of the switching device to the supporting component, wherein
the inverter circuit is configured to convert a direct current input to the inverter device into an alternating current.

2. The inverter device according to claim 1, wherein the second component comprises any one of the following:
a batten component, a heat dissipation block component, and a fastener.

3. The inverter device according to claim 2, wherein
the second component is the batten component, the body of the switching device is located between the batten component and the supporting component, and the batten component is configured to press the body of the switching device toward the supporting component; and
the first component is located between the batten component and the supporting component.

4. The inverter device according to claim 2, wherein
the second component is the heat dissipation block component, the body of the switching device is fastened to the heat dissipation block component, and the heat dissipation block component is connected to the supporting component; and
the first component is located between the body of the switching device and the heat dissipation block component; or
the first component is located between the heat dissipation block component and the supporting component.

5. The inverter device according to claim 2 or 3, wherein the batten component comprises:
a fastening part and a connection part, wherein
the fastening part is configured to compress contact between the body of the switching device and the supporting component, and the body of the switching device is located between the fastening part and the supporting component; and
the connection part is connected to the supporting component through the fastener.

6. The inverter device according to any one of claims 1 to 5, wherein the supporting component comprises:
a first surface and a second surface, wherein
the first surface is in contact with the surface, facing the circuit substrate, of the bottom plate of the housing; and
the second surface is used for placing the body of the switching device.

7. The inverter device according to any one of claims 2 to 6, wherein a constituent material of the heat dissipation block component comprises a metal material.

8. The inverter device according to any one of claims 1 to 7, wherein the inverter circuit further comprises:
a magnetic power device, wherein the magnetic power device comprises pins and a body, and the pins of the magnetic power device are mounted on the same plane.

9. The inverter device according to any one of claims 1 to 8, wherein
the surface, facing the circuit substrate, of the bottom plate of the housing comprises a first plane and a second plane, and the first plane and the second plane are respectively located on two sides of the supporting component.

10. The inverter device according to claim 9, wherein the first plane is flush with the second plane.

11. The inverter device according to claim 9 or 10, wherein the first plane comprises a second cavity, and all or a part of the body of the through-hole device is located in the second cavity.

12. The inverter device according to any one of claims 9 to 11, wherein the second plane comprises a third cavity, and all or a part of the body of the magnetic power device is located in the third cavity.
